# DEMANDE DE BREVET EUROPEEN

(11) **EP 1 059 669 A1**
(43) Date de publication de la demande: **13.12.2000**
(21) Numéro de dépôt: 00401564.0
(22) Date de dépôt: 02.06.2000
(51) Int. Cl.: H01L 27/112, G11C 11/56, G11C 8/00

(54) **Dispositif semiconducteur intégré de mémoire morte**

(30) Priorité: 11.06.1999 FR 9907429
(71) Demandeur: STMicroelectronics SA, 94250 Gentilly (FR)
(72) Inventeur: Schoellkopf, Jean-Pierre, 38000 Grenoble (FR)
(74) Mandataire: Casalonga, Axel

(57) **Abrégé**

Le dispositif semiconducteur intégré de mémoire morte comprend au moins une cellule-mémoire CM1 comportant un transistor de mémorisation T1 réalisé au sein d'un substrat semiconducteur et dont la source S1 est reliée à la masse, une ligne de mot WL12 reliée à la grille G1 du transistor, et plusieurs lignes de bits BL0, BL1, BL2 dont l'une au plus est reliée au drain D1 du transistor.

## Description

L'invention concerne les mémoires mortes (mémoires ROM : "Read Only Memory" en langue anglaise), c'est-à-dire les mémoires auxquelles on ne peut accéder qu'en lecture pour lire le contenu de l'information qui y est mémorisé.

Les mémoires mortes classiques comportent un réseau de cellules-mémoire élémentaires (point mémoire) disposées en lignes et en colonnes. Toutes les cellules-mémoire d'une même ligne sont activées par une première métallisation (ligne de mot ; "word line" en langue anglaise), tandis que toutes les cellules d'une même colonne sont susceptibles d'être lues à partir de la tension aux bornes d'une métallisation de colonnes (lignes de bit ; "bit line" en langue anglaise).

Plus précisément, l'activation d'une ligne de mot et la mesure de la tension aux bornes d'une ligne de bit va permettre de lire le contenu de la cellule-mémoire située à l'intersection de cette ligne de mot et de cette ligne de bit. La valeur de l'information mémorisée dépend alors du niveau (haut ou bas) de la tension sur la ligne de bit.

Une cellule-mémoire morte classique ne permet donc de coder qu'un mot numérique d'un bit (pouvant prendre les deux valeurs zéro ou un).

L'invention vise à proposer un dispositif intégré de mémoire morte offrant une plus grande densité de codage, c'est-à-dire permettant de coder plus d'un bit par cellule-mémoire.

L'invention a également pour but d'augmenter la vitesse de lecture de chaque cellule.

L'invention a encore pour but de proposer un dispositif intégré de mémoire morte dont certains blocs de cellule peuvent coder des mots de plusieurs bits (par exemple quatre bits) avec un encombrement réduit par rapport à l'encombrement de quatre cellules-mémoire de l'art antérieur nécessaires pour le codage de ces quatre bits.

L'invention propose donc un dispositif semiconducteur intégré de mémoire morte, comprenant au moins une cellule-mémoire comportant un transistor de mémorisation réalisé au sein d'un substrat semiconducteur dont la source est reliée à la masse, une première ligne de métallisation (ligne de mot) reliée à la grille du transistor, et plusieurs (au moins deux) lignes de métallisation auxiliaires (lignes de bits) dont l'une au plus est reliée au drain du transistor.

En d'autres termes, on associe à chaque cellule-mémoire non pas une seule ligne de bit, mais plusieurs, c'est-à-dire au moins deux. Et, de façon à éviter un court-circuit entre les lignes de bits, on autorise la connexion au maximum au drain du transistor que d'une seule ligne de bit . Ceci permet de coder plus que deux valeurs par cellule-mémoire (par exemple quatre valeurs pour trois lignes de bits formant un mot numérique de deux bits). Le choix de la ligne de bit qui est éventuellement reliée au drain du transistor dépend de la valeur de l'information binaire que l'on souhaite programmer (écrire) dans la cellule-mémoire lors de sa fabrication. Bien entendu, il est également possible de ne relier aucune des lignes de bits au drain du transistor, ce qui permet de coder une valeur particulière du mot numérique contenu dans la cellule-mémoire.

Les lignes de métallisation auxiliaires (lignes de bits) peuvent être parallèles et situées les unes au-dessus des autres respectivement à des niveaux de métallisation différents au-dessus du substrat semiconducteur. On obtient alors des cellules-mémoire multi-niveaux.

Un tel mode de réalisation permet, outre l'augmentation de la densité de codage, de réaliser des transistors de mémorisation de plus grande taille permettant donc une lecture plus rapide du contenu de la cellule-mémoire sélectionnée.

Il est également possible en variante que les lignes de métallisation auxiliaires soient parallèles et situées les unes à côté des autres sur un même niveau de métallisation.

D'autres avantages et caractéristiques de l'invention apparaîtront à l'examen de la description détaillée de modes de réalisation, nullement limitatifs, et des dessins annexés, sur lesquels :
- la figure 1 illustre schématiquement le principe de fonctionnement d'une cellule-mémoire morte, principe qui s'applique également aux cellules selon l'invention;
- les figures 2 à 4 illustrent schématiquement et partiellement un premier mode de réalisation d'un dispositif intégré de mémoire-morte selon l'invention, dans lequel chaque cellule-mémoire morte est associée à trois lignes de bits;
- la figure 5 illustre schématiquement un circuit logique, pouvant être connecté à une cellule-mémoire morte à trois lignes de bits et permettant de délivrer en sortie un mot numérique codé sur deux bits et représentatif du contenu de l'information mémorisée dans cette cellule-mémoire;
- la figure 6 illustre un autre circuit logique permettant de convertir simplement de la logique ternaire en logique binaire, et qui peut être utilisé en combinaison avec une paire de cellules-mémoire selon l'invention associées chacune à deux lignes de bits; et
- la figure 7 illustre un autre mode de réalisation d'une cellule-mémoire selon l'invention.

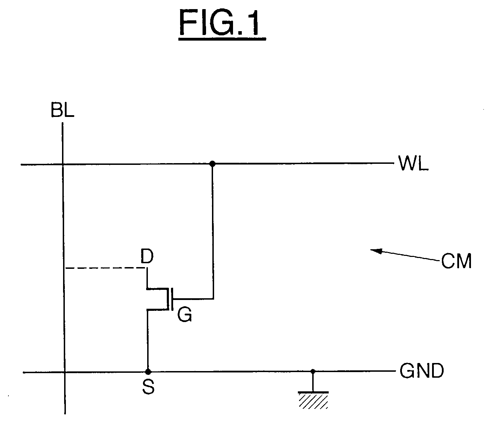

Sur la figure 1, la référence CM désigne une cellule-mémoire morte comportant un transistor de mémorisation T dont la source S est reliée à une métallisation GND elle-même reliée à la masse. La grille du transistor de mémorisation T est reliée à une première métallisation WL communément désignée par l'homme du métier "ligne de mot" ("word line" en langue anglaise).

On a représenté sur la figure 1, à des fins de simplification, qu'une seule ligne de bit BL ("bit line" en langue anglaise), également désignée dans le texte de la présente demande de brevet par le vocable "métallisation auxiliaire", afin de se distinguer de la première métallisation qui est la ligne de mot. Ceci étant, le principe de lecture qui va maintenant être décrit en référence à la figure 1, s'applique également aux cellules-mémoire selon l'invention qui sont associées, comme on le verra plus en détail ci-après, à plusieurs lignes de bits mais dont, de toutes façons, une seule au maximum est éventuellement reliée au drain du transistor de mémorisation.

Lors de la fabrication de la cellule-mémoire au sein du circuit intégré, on relie ou on ne relie pas la ligne de bit BL au drain du transistor de mémorisation. Ceci a une influence, comme on le verra plus en détail ci-après sur la valeur de l'information mémorisée dans la cellule-mémoire. Et, lors de la lecture de la cellule-mémoire, on précharge de façon classique la ligne de bit avec la tension d'alimentation Vdd. Lorsque la ligne de mot WL est activée (par l'application par exemple de la tension d'alimentation sur cette ligne de mot), le transistor T est passant. En conséquence, si la ligne de bit BL est reliée au drain du transistor T, celle-ci va se décharger et la tension aux bornes de la ligne de bit BL va chuter. Par contre, si la ligne de bit n'est pas reliée au drain du transistor, celle-ci ne se déchargera pas et la tension aux bornes de la ligne de bit BL restera à sa valeur nominale Vdd (aux fuites près). On affecte alors par exemple la valeur binaire 1 lorsque la tension de la ligne de bit reste égale à la tension d'alimentation Vdd, tandis qu'on affecte la valeur binaire 0 lorsque la ligne de bit B1 se décharge.

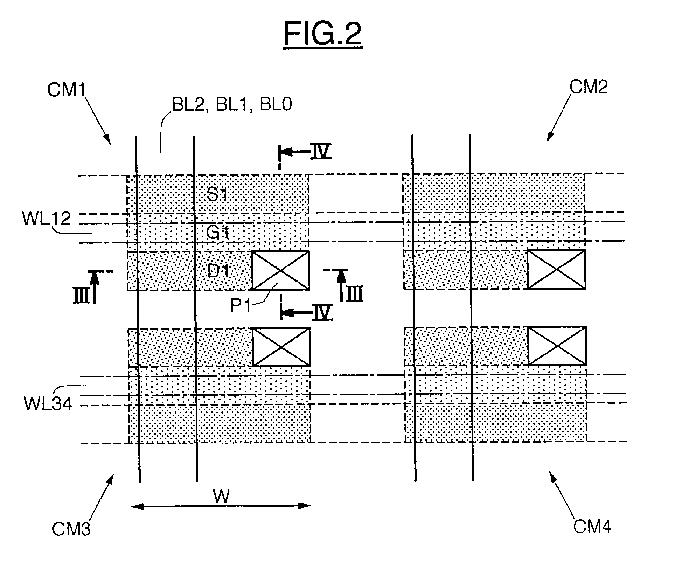

Sur la figure 2, les références CM1, CM2, CM3 et CM4 désignent quatre cellules-mémoire selon l'invention appartenant à un plan-mémoire du dispositif intégré de mémoire selon l'invention.

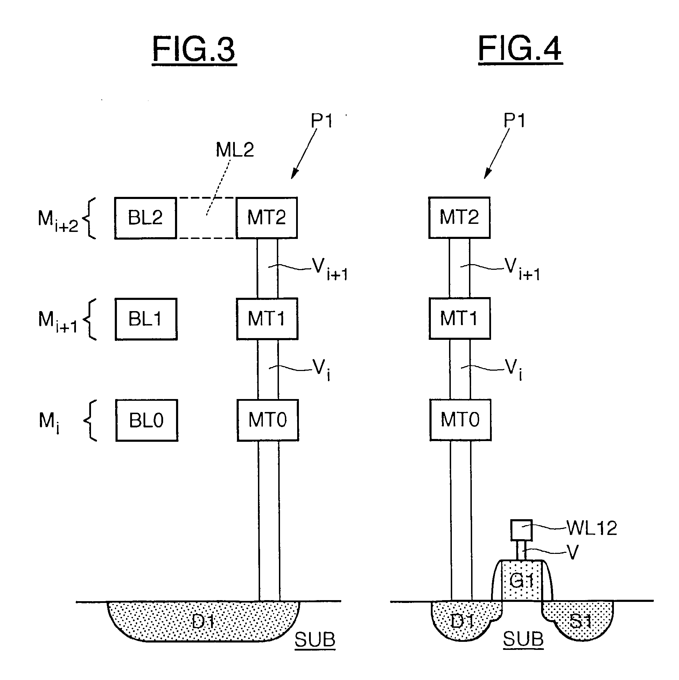

Chaque cellule-mémoire (par exemple la cellule CM1) comporte un transistor de mémorisation réalisé de façon classique et connue en soi au sein d'un substrat semiconducteur et comportant une zone de source S1, une zone de drain D1 et une zone de grille G1. La configuration de ce transistor de mémorisation est également représentée sur la figure 4 qui représente une coupe schématique partielle selon la ligne IV-IV de la figure 2.

Les sources des transistors d'une même ligne sont reliées ensemble à la masse.

La référence WL12 désigne une première métallisation ou ligne de mot reliée à toutes les grilles des transistors de mémorisation des cellules-mémoire d'une même ligne du plan-mémoire. La ligne de mot WL12 est par conséquent reliée à la grille G1 du transistor de mémorisation de la cellule CM1, et ce, de façon classique et connue en soi, par une interconnexion métallique V (figure 4) communément désignée par l'homme du métier sous le vocable "via" ou "contact".

Par ailleurs, comme illustré plus particulièrement sur la figure 4, mais aussi sur la figure 3 qui représente une coupe schématique partielle selon la ligne III-III de la figure 2, la cellule-mémoire CM1 est associée à plusieurs métallisations auxiliaires ou lignes de bits (ici trois), BL0, BL1 et BL2. Ces lignes de bits BL0, BL1 et BL2 s'étendent dans une direction perpendiculaire aux lignes de mots et définissent une colonne du plan-mémoire. Et toutes les cellules-mémoires de cette colonne sont associées à ces trois lignes de bits, en l'espèce la cellule-mémoire CM1, mais également la cellule-mémoire CM3.

Dans ce mode de réalisation, les lignes de bits BL0, BL1 et BL2 sont parallèles et situées les unes au-dessus des autres, respectivement à des niveaux de métallisation différents au-dessus du substrat semiconducteur SUB. En l'espèce, elles sont réalisées respectivement aux niveaux de métallisation Mᵢ, Mᵢ₊₁ et Mᵢ₊₂.

La cellule-mémoire CM1 comporte, par ailleurs, un moyen métallique vertical de connexion, ou pilier métallique P1, possédant une première extrémité au contact du drain D1 du transistor de mémorisation de la cellule. Ce pilier métallique P1 s'étend verticalement et perpendiculairement aux différents niveaux de métallisation.

Plus précisément, ce pilier P1 comporte des portions de métal MT0, MT1 et MT2 respectivement situées aux niveaux de métallisation Mᵢ, Mᵢ₊₁ et Mᵢ₊₂. Les portions métalliques MT1 et MT2 sont mutuellement reliées par un via Vᵢ₊₁, tandis que les portions métalliques MT1 et MT0 sont mutuellement reliées par un via Vᵢ. La portion métallique MT0 est également reliée par un autre via au drain D1 du transistor.

En fonction de la valeur de l'information numérique destinée à être mémorisée dans la cellule-mémoire CM1, l'une seulement des lignes de bits BL0, BL1, BL2, ou bien aucune de ces lignes de bits, sera reliée au pilier P1, lors de la fabrication de la cellule-mémoire.

La programmation de la cellule-mémoire, c'est-à-dire sa fabrication avec la valeur mémorisée souhaitée, nécessite alors trois masques pour les trois niveaux de métallisation Mᵢ, Mᵢ₊₁ et Mᵢ₊₂. Dans l'exemple illustré sur les figures 2 à 4, c'est la ligne de bit BL2 qui est reliée au pilier P1 par une métallisation de connexion horizontale ML2 reliant la ligne de bit sélectionnée BL2 au pilier P1;

Si l'on suppose qu'une valeur logique 1 est associée à une ligne de bit non connectée au pilier P1 et qu'une valeur logique 0 est associée à une ligne de bits connectée au pilier P1, la cellule-mémoire CM1 illustrée sur la figure 3 code donc la valeur 011 (respectivement associée aux lignes de bits BL2, BL1 et BL0).

On lira effectivement cette valeur lors de l'activation de la cellule CM1. En effet, une fois que les trois lignes de bits BL0, BL1 et BL2 auront été préchargées à la tension d'alimentation Vdd et que la ligne de mot WL12 aura été activée, seule la ligne de bit BL2 se déchargera et l'on mesurera effectivement un niveau bas de tension sur la ligne BL2 correspondant à la valeur 0, tandis qu'on mesurera un niveau haut de tension sur les lignes BL0 et BL1 correspondant aux valeurs 1 et 1.

Outre la programmation de la cellule CM1, illustrée sur la figure 3, trois autres programmations sont possibles, à savoir la programmation de la valeur 111 lorsqu'aucune des lignes de bits BL0, BL1 et BL2 n'est connectée au pilier P1, ou bien la valeur 101 lorsque seule la ligne de bit BL1 est reliée au pilier P1, ou encore la valeur 110 lorsque seule la ligne de bit BL0 est reliée au pilier P1;

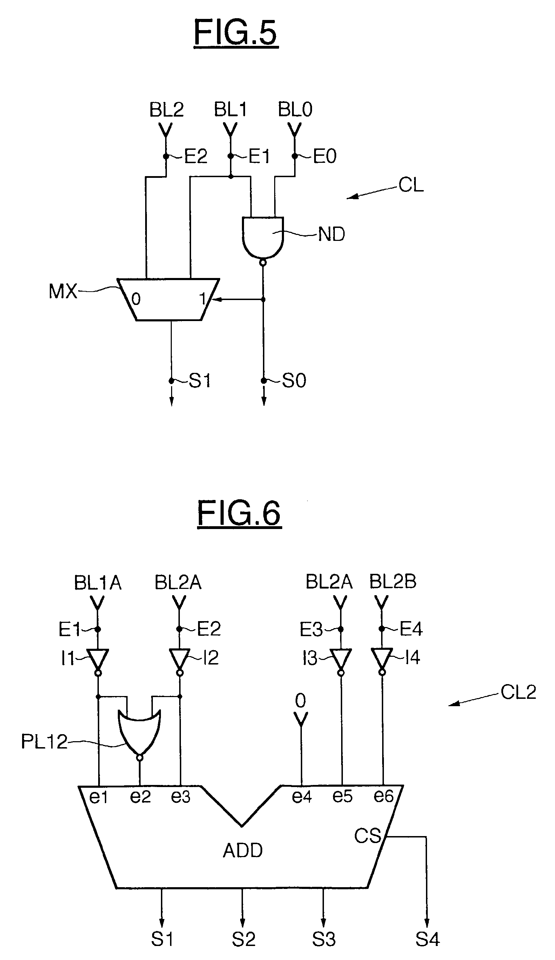

On associe alors à cette cellule-mémoire CM1, et en fait à l'ensemble du plan-mémoire par l'intermédiaire d'un multiplexeur, un circuit logique CL tel que celui illustré sur la figure 5, permettant de convertir la valeur mémorisée dans la cellule, et prise parmi les quatre valeurs possibles de mémorisation, en un mot numérique de sortie codé sur deux bits.

Plus particulièrement, ce circuit logique de conversion CL possède trois entrées E2, E1 E0, respectivement connectées aux trois lignes de bits de la cellule-mémoire CM1 et deux sorties S1, S0 délivrant les deux bits du mot de sortie. Les moyens logiques connectés entre les trois entrées et les deux sorties et qui permettent d'effectuer cette conversion, comportent par exemple une porte logique NON-ET, référencée ND, dont les deux entrées sont respectivement reliées aux deux entrées E0 et E1 du circuit logique CL et dont la sortie est reliée à la sortie S0 du circuit logique.

Les moyens logiques de conversion comportent également un multiplexeur MX dont les deux entrées sont respectivement reliées aux entrées E1 et E2 du circuit logique et dont la sortie est reliée à l'autre sortie S1 du circuit logique CL. L'entrée de commande du multiplexeur MX est reliée à la sortie de la porte logique ND.

Les trois entrées E0, E1 et E2 sont respectivement reliées aux trois lignes de bits BL0, BL1 et BL2.

Ainsi, la valeur logique mémorisée 110, respectivement délivrée aux entrées E2, E1 et E0, fournira en sortie la valeur 11 pour le mot de sortie de deux bits.

De même, la valeur mémorisée 111 fournira en sortie la valeur 10 pour le mot de sortie, tandis que la valeur mémorisée 101 fournira la valeur 01 pour le mot de sortie et que la valeur mémorisée 011 fournira la valeur 00 pour le mot de sortie.

L'homme du métier aura donc remarqué que cette cellule-mémoire permet de coder un mot numérique de deux bits en utilisant trois lignes de bits. On a donc une densité de codage de deux bits par colonne, c'est-à-dire de deux bits par cellule-mémoire.

Par ailleurs, du fait que l'empilement des lignes de bits se situe à côté du pilier métallique P1, la largeur W du transistor (figure 2) peut être plus importante que celle d'un transistor d'une cellule-mémoire classique ne comportant qu'une seule ligne de bit (largeur alors égale à celle de la ligne de bit). Par conséquent, la vitesse de lecture d'une telle cellule-mémoire selon l'invention est plus importante.

Lorsqu'une cellule-mémoire selon l'invention est associée à deux lignes de bits, il est alors possible de coder trois valeurs, à savoir la valeur 11 lorsqu'aucune des lignes de bits n'est connectée au pilier métallique, c'est-à-dire au drain du transistor de mémorisation, ou bien la valeur 01 ou 10 lorsque l'une ou l'autre des deux lignes de bits est connectée au drain du transistor de mémorisation.

Ces trois valeurs possibles de mémorisation forment un chiffre ternaire ("ternary digit" en langue anglaise).

Si l'on associe deux cellules-mémoire associées chacune à deux lignes de bits, par exemple deux cellules-mémoire de deux colonnes adjacentes, il est ainsi possible de mémoriser, à l'aide de ces deux chiffres ternaires, neuf valeurs possibles, parmi lesquelles on peut en choisir seulement huit pour produire un mot de sortie codé sur trois bits, affecté d'un bit de validité.

Plus précisément, si la référence BL1A et BL2A désigne les deux lignes de bits de l'une des deux cellules-mémoire, et si BL1B et BL2B désignent les deux lignes de bits homologues de l'autre cellule-mémoire, les neuf valeurs possibles mémorisées par ce couple de deux cellules-mémoire sont représentées dans les quatre premières colonnes correspondantes du tableau 1 ci-dessous.

**TABLEAU 1**

| BL1A | BL2A | BL1B | BL2B | Mot de sortie | S4 |
|---|---|---|---|---|---|
| 1 | 1 | 1 | 1 | 000 | 0 |
| 1 | 1 | 1 | 0 | 001 | 0 |
| 1 | 1 | 0 | 1 | 010 | 0 |
| 1 | 0 | 1 | 1 | 011 | 0 |
| 1 | 0 | 1 | 0 | 100 | 0 |
| 1 | 0 | 0 | 1 | 101 | 0 |
| 0 | 1 | 1 | 1 | 110 | 0 |
| 0 | 1 | 1 | 0 | 111 | 0 |
| | | | | | |
| 0 | 1 | 0 | 1 | 000 | 1 |

Les quatre lignes de bits BL1A, BL2A, BL1B et BL2B sont respectivement reliées aux quatre entrées E1, E2, E3, E4 d'un circuit de conversion ternaire-binaire CL2 tel que celui illustré sur la figure 6. Ce circuit de conversion ternaire-binaire possède par ailleurs quatre sorties et des moyens logiques de conversion connectés entre les quatre entrées et les quatre sorties et aptes à convertir la valeur mémorisée dans les deux cellules et prises parmi les neuf valeurs possibles de mémorisation, en un mot de sortie codé sur trois bits S1, S2, S3, affecté d'un bit de contrôle S4.

Plus précisément, ces moyens logiques de conversion comportent, comme illustré sur la figure 6, une porte logique OU, référencée PL12 et un additionneur binaire 3 bits ADD dont les trois sorties sont reliées aux trois sorties du circuit pour délivrer le mot de sortie, et dont la sortie de retenue CS est reliée à la quatrième sortie S4 pour délivrer le bit de contrôle.

La première entrée e 1 de l'additionneur ADD est reliée à l'entrée E1 par l'intermédiaire d'un inverseur I1. La troisième entrée e3 de l'additionneur ADD est reliée à l'entrée E2 par l'intermédiaire d'un inverseur I2. Les sorties des deux inverseurs I1 et I2 sont par ailleurs reliées aux deux entrées de la porte logique PL12 dont la sortie est reliée à la deuxième entrée e2 de l'additionneur ADD.

La quatrième entrée e4 de l'additionneur ADD est reliée de façon câblée à la valeur logique zéro (la masse), tandis que les cinquième et sixième entrées e5 et e6 de l'additionneur ADD sont respectivement reliées aux entrées E3 et E4 du circuit logique CL2 par l'intermédiaire de deux autres inverseurs I3 et I4.

Ainsi, les neuf valeurs possibles du mot de sortie codé sur trois bits sont fournies dans la cinquième colonne du tableau 1, tandis que la dernière colonne du tableau indique pour chacun des mots de sortie la valeur du bit de retenue S4.

L'homme du métier remarque alors que les huit premières valeurs possibles mémorisées dans les deux cellules-mémoire conduisent à huit valeurs possibles du mot de sortie de trois bits affectées toutes d'une retenue égale à 0, tandis que la neuvième valeur possible de mémorisation (dernière ligne du tableau 1) conduit à un mot de sortie de trois bits égal à 000 mais affecté d'une retenue égale à 1.

L'utilisation de la retenue S4 permet de valider le contenu de l'information mémorisée dans la paire de cellules-mémoire adressées (information valide lorsque la retenue est égale à 0) et de considérer cette information lue comme invalide si la retenue est égale à 1. On peut ainsi, dans une application logicielle, programmer des couples de cellules-mémoire situés à des adresses prédéterminées et qui doivent être à priori interdites d'accès pour un processur, avec la configuration interdite 0101. Si, au cours du déroulement du logiciel, la retenue S4 passe à 1 lors de la lecture d'un couple de cellules-mémoire, cela signifiera que le processeur est allé lire une information à une adresse interdite.

L'utilisation de deux cellules-mémoire couplées ayant chacune deux lignes de bits, permet donc d'obtenir une densité de codage de trois bits pour deux cellules (trois bits pour deux colonnes), soit 1,5 bits par cellule, avec en outre une indication sur la validité de l'information lue.

Par ailleurs, le circuit logique de conversion ternaire-binaire CL2 qui vient d'être décrit en combinaison avec deux cellules-mémoire selon l'invention à deux lignes de bits chacune, peut en fait être utilisé indépendamment de cette application de mémoire morte, pour toute application en général de conversion de logique ternaire en logique binaire. Et, quelle que soit l'application, ce circuit de conversion ternaire-binaire est remarquable par sa simplicité de réalisation.

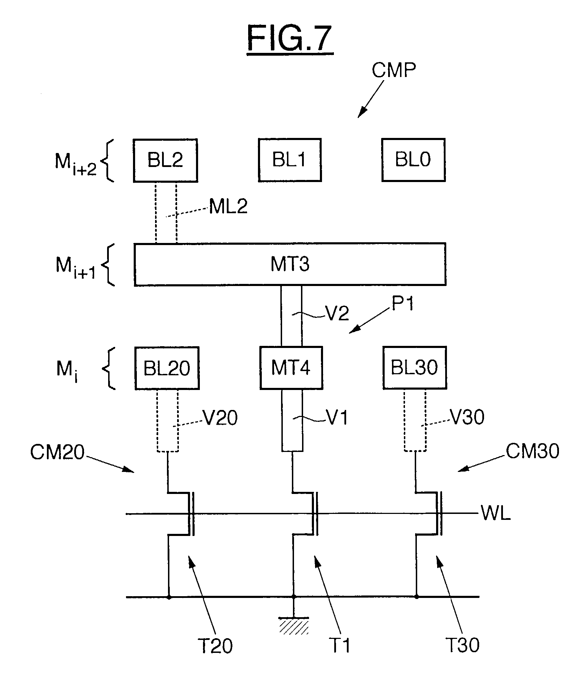

La figure 7 illustre un autre mode de réalisation de l'invention, mettant en oeuvre une cellule-mémoire CMP à trois lignes de bits BL0, BL1 et BL2, qui sont cette fois-ci parallèles et situées les unes à côté des autres sur un même niveau de métallisation supérieur Mᵢ₊₂ situé au-dessus du substrat semiconducteur.

Là encore, seule l'une au maximum de ces lignes de bits BL0, BL1 ou BL2 devra être connectée au transistor de mémorisation T1 de cette cellule-mémoire.

A cet égard, il est prévu que cette cellule-mémoire comporte une ligne de métallisation intermédiaire MT3 située à un niveau de métallisation intermédiaire Mᵢ₊₁ entre le substrat et le niveau supérieur Mᵢ₊₂, ainsi qu'un pilier métallique vertical P1 possédant une première extrémité au contact du drain du transistor T1 et une deuxième extrémité au contact de la ligne de métallisation intermédiaire MT3.

Ce pilier métallique vertical P1 est constitué ici d'un via V2 reliant la ligne de métallisation intermédiaire MT3 à une portion de métal MT4 située au niveau de métallisation Mᵢ, et d'un via V1 reliant la portion de métal MT4 au drain du transistor T1.

Si, lors de la programmation de cette cellule-mémoire, l'une des lignes de bits BL0, BL1 ou BL2 doit être reliée au drain du transistor T1, il est prévu de connecter cette ligne de bits (par exemple BL2) à la ligne de métallisation intermédiaire MT3 par une métallisation de connexion verticale (un via) ML2.

Le bloc-mémoire illustré sur la figure 7 comporte outre cette cellule-mémoire CMP (que l'on dénomme ici cellule-mémoire principale) à trois lignes de bits parallèles BL0, BL1 et BL2, deux cellules-mémoire annexes comportant chacune un transistor de mémorisation annexe T20, T30.

Les deux transistors de mémorisation annexes T20 et T30, ainsi que le transistor de mémorisation T1 de la cellule-mémoire principale sont reliés ensemble à la même ligne de mots WL.

Par ailleurs, chaque cellule-mémoire annexe ne comporte cette fois-ci qu'une seule ligne de métallisation annexe (ligne de bit) BL20, BL30, reliée ou non au drain du transistor annexe correspondant, en fonction de la programmation désirée pour chacune de ces deux cellules-mémoire annexes CM20, CM30.

Par ailleurs, chaque ligne de bit annexe BL20, BL30 est située de part et d'autre du pilier métallique P1 à un même niveau de métallisation annexe Mᵢ situé sous la ligne de métallisation intermédiaire MT3.

Chaque ligne de bit annexe est située sous l'une des lignes de bits de la cellule-mémoire principale. En l'espèce, la ligne de bit BL20 est située sous la ligne de bit BL2, tandis que la ligne de bit BL30 est située sous la ligne de bit BL0;

L'homme du métier remarque donc qu'il est possible de mémoriser dans ce bloc-mémoire formé des cellules CMP, CM20, CM30, seize valeurs binaires différentes (2 x 2 x 4), à savoir deux valeurs possibles pour la cellule-mémoire annexe CM20 associée à la ligne de bit BL20, deux valeurs possibles pour la cellule-mémoire annexe CM30 associée à la ligne de bit BL30 et quatre valeurs possibles pour la cellule-mémoire principale CMP associée aux trois lignes de bits BL0, BL1 et BL2.

Aussi, il est prévu d'associer à ce bloc-mémoire un circuit de conversion (non représenté ici à des fins de simplification), possédant cinq entrées respectivement connectées aux trois lignes de bits BL0, BL1 et BL2 de la cellule-mémoire principale et aux deux lignes de bits annexes BL20 et BL30 des deux cellules-mémoire annexes. Ce circuit de conversion comporte alors quatre sorties et des moyens logiques connectés entre les cinq entrées et les quatre sorties, et aptes à convertir la valeur mémorisée dans le bloc-mémoire et prises parmi les seize valeurs possibles de mémorisation, en un mot de sortie codé sur quatre bits.

De tels moyens logiques de conversion sont aisément réalisables par l'homme du métier.

Ainsi, ce mode de réalisation permet de coder un mot de quatre bits en utilisant un encombrement de trois colonnes de métallisation. En d'autres termes, on code seize valeurs (ou quatre bits) sur trois pistes, ce qui conduit à une densité de quatre tiers de bits par piste métallique alors qu'un plan-mémoire de l'art antérieur aurait nécessité l'utilisation de quatre colonnes adjacentes (donc quatre pistes métalliques).

## Revendications

1. Dispositif semiconducteur intégré de mémoire morte, caractérisé par le fait qu'il comprend au moins une cellule-mémoire (CM1) comportant un transistor de mémorisation (T1) réalisé au sein d'un substrat semiconducteur et dont la source (S1) est reliée à la masse, une première ligne de métallisation (WL12) reliée à la grille (G1) du transistor, et plusieurs lignes de métallisation auxiliaires (BL0, BL1, BL2) dont l'une au plus est reliée au drain (D1) du transistor.

2. Dispositif selon la revendication 1, caractérisé par le fait les lignes de métallisation auxiliaires (BL0, BL1, BL2) sont parallèles et situées les unes au dessus des autres respectivement à des niveaux de métallisation différents au dessus du substrat semiconducteur (SUB), par le fait que la cellule-mémoire comporte d'une part un pilier métallique (P1) possédant une première extrémité au contact du drain du transistor et s'étendant verticalement perpendiculairement aux différents niveaux de métallisation, et d'autre part, si l'une des lignes auxiliaires est reliée au drain du transistor, une métallisation de connexion horizontale (ML2) reliant la ligne de métallisation auxiliaire sélectionnée au pilier.

3. Dispositif selon la revendication 1 ou 2, caractérisé par le fait que la cellule-mémoire comporte trois lignes de métallisation auxiliaires (BL0, BL1, BL2) et par le fait que le dispositif comporte un circuit de conversion (CL) possédant trois entrées respectivement connectées aux trois lignes de métallisation auxiliaires de la cellule, deux sorties et des moyens logiques connectés entre les trois entrées et les deux sorties et aptes à convertir la valeur mémorisée dans la cellule et prise parmi quatre valeurs possibles de mémorisation, en un mot de sortie codé sur deux bits.

4. Dispositif selon la revendication 1 ou 2, caractérisé par le fait qu'il comprend au moins deux cellules-mémoire comportant chacune deux lignes de métallisation auxiliaires, ainsi qu'un circuit de conversion ternaire/binaire (CL2) possédant quatre entrées respectivement connectées aux quatre lignes de métallisation auxiliaires des deux cellules, quatre sorties, et des moyens logiques de conversion connectés entre les quatre entrées et les quatre sorties et aptes à convertir la valeur mémorisée dans les deux cellules et prise parmi neufs valeurs possibles de mémorisation, en un mot de sortie codé sur trois bits (S1, S2, S3) affecté d'un bit de contrôle (S4).

5. Dispositif selon la revendication 4, caractérisé par le fait que les moyens logiques de conversion comportent une porte logique OU (PL12) et un additionneur binaire 3 bits (ADD) dont les trois sorties sont reliées aux trois sorties du circuit pour délivrer le mot de sortie et dont la sortie de retenue (CS) est relié à la quatrième sortie pour délivrer le bit de contrôle.

6. Dispositif selon la revendication 1, caractérisé par le fait que les lignes de métallisation auxiliaires (BL0, BL1, BL2) sont parallèles et situées les unes à côté des autres sur un même niveau de métallisation supérieur (Mᵢ₊₂) situé au-dessus du substrat semiconducteur, par le fait que la cellule-mémoire comporte d'une part une ligne de métallisation intermédiaire (MT3) située à un niveau de métalisation intermédiaire (Mᵢ₊₁) entre le substrat et le niveau supérieur ainsi qu'un un pilier métallique vertical (P1) possédant une première extrémité au contact du drain du transistor et une deuxième extrémité au contact de la ligne de métallisation intermédiaire, et d'autre part, si l'une des lignes de métallisation auxiliaires (BL0, BL1, BL2) est reliée au drain du transistor, une métallisation de connexion verticale (ML2) reliant la ligne de métallisation auxiliaire sélectionnée (BL2) à la ligne de métallisation intermédiaire (MT3).

7. Dispositif selon la revendication 6, caractérisé par le fait qu'il comprend un bloc-mémoire comprenant une cellule mémoire principale (CMP) comportant trois lignes de métallisation auxiliaires (BL0, BL1, BL2), ainsi que deux cellules-mémoire annexes (CM20, CM30) comportant chacune un transistor de mémorisation annexe relié à la première ligne de métallisation (WL) de la cellule mémoire principale (CMP) ainsi qu'une seule ligne de métallisation annexe (BL20, BL30) reliée ou non au drain du transistor annexe, par le fait que chaque ligne de métallisation annexe (BL20, BL30) est située de part et d'autre du pilier métallique (P1) à un même niveau de métallisation annexe (Mᵢ) situé sous la ligne de métallisation intermédiaire (MT3), par le fait que chaque ligne de métallisation annexe est située sous l'une des ligne de métallisation auxilaires de la cellule mémoire principale, et par le fait qu'il comprend en outre un circuit de conversion possédant cinq entrées respectivement connectées aux trois lignes de métallisation auxiliaires de la cellule principale et aux deux lignes de métallisation auxiliaires annexes des deux cellules annexes, quatre sorties et des moyens logiques connectés entre les cinq entrées et les quatre sorties et aptes à convertir la valeur mémorisée dans le bloc mémoire et prise parmi seize valeurs possibles de mémorisation, en un mot de sortie codé sur quatre bits.
